# EUROPEAN PATENT APPLICATION

(11) **EP 4 503 127 A1**
(43) Date of publication of application: **05.02.2025**
(21) Application number: 23188677.1
(22) Date of filing: 31.07.2023
(51) Int. Cl.: H01L 27/02, H03K 17/0814, H02H 9/04

(54) **A SEMICONDUCTOR DEVICE**

(71) Applicant: Nexperia B.V., 6534 AB Nijmegen (NL)
(72) Inventor: Qu, Yong, Manchester, SK7 5BJ (GB); Brown, Adam, Manchester, SK7 5BJ (GB); Hsu, Chih-Wei, Manchester (GB); Cheng, Yang, Dongguan (CN); Zha, Peilin, Dongguan (CN); Radici, Christian, Manchester (GB)
(74) Representative: Pjanovic, Ilija

(57) **Abstract**

A semiconductor device comprising:
a power switching component configured to control the flow of current through a load path;
a current sensing component configured to sense the current flow through the load path; and
an electrostatic discharge "ESD" protection component configured to protect the current-sensing component from an electrostatic discharge, wherein the ESD protection component comprises an ESD transistor, the ESD transistor having a gate which is connected to a discharge path such that the presence of a discharge of a first polarity causes the ESD transistor to switch on to form a further path for dissipation of a discharge.

## Description

### Field of the invention

Embodiments described herein generally relate to semiconductor devices.

### Background

In power electronics, accurate sensing of the current flowing through a load path controlled by a semiconductor switch such as a transistor is required. This can be accomplished through various current-sensing technologies, for example, a current mirror arrangement using a transistor. The current through the load path can be measured by measuring the current through the sense transistor.

However, typically the sense transistor is small and therefore any electrostatic discharge which may occur can damage the sense transistor.

### Brief Description of the Drawings

The present disclosure will now be described with reference to the accompanying drawings, which are provided for aiding in explanation and understanding. The accompanying drawings should not be taken to limit the present disclosure to the specific embodiments described herein.
Fig. 1 is a schematic illustrating an electrostatic discharge (ESD) protection component in accordance with an embodiment;
Fig. 2 is a schematic illustrating an ESD protection component and resistor in accordance with an embodiment;
Fig. 3A is a circuit diagram of semiconductor device with MOSFETs in accordance with an embodiment;
Fig. 3B is a circuit diagram of semiconductor device with GaN based transistors in accordance with an embodiment;
Figs. 4A - 4B are circuit diagrams showing an ESD transistor and resistor in operation as part of example sensing circuitry in accordance with an embodiment.
Fig. 5 is a circuit diagram showing a configuration of multiple ESD transistors and resistors in accordance with an embodiment;
Fig. 6 is a graph showing standard ESD profiles;
Fig. 7A is a circuit diagram illustrating a simulation testbench with a negative sense source voltage (-V_{LSS}) with respect to the main source (V_{LS});
Fig. 7B is a circuit diagram illustrating a simulation test bench with a positive sense source voltage (+V_{LSS}) with respect to the main source (V_{LS});
Fig. 8 is a circuit diagram illustrating a simulation test bench with a gate driver connected;
Fig. 9 is a schematic illustrating an ESD resistor in accordance with an embodiment;
Fig. 10A is a circuit diagram showing an ESD resistor in more detail;
Figs. 10B and 10C are circuit diagrams showing an ESD resistor in operation as part of example sensing circuitry in accordance with an embodiment.
Fig. 11 is a circuit diagram showing a generic Smart Power Stage (SPS) sense FET configuration;

### Detailed Description

In an embodiment, a semiconductor device is provided comprising:
a power switching component configured to control the flow of current through a load path;
a current sensing component configured to sense the current flow through the load path; and
an electrostatic discharge "ESD" protection component configured to protect the current-sensing component from an electrostatic discharge, wherein the ESD protection component comprises an ESD transistor, the ESD transistor having a gate which is connected to a discharge path such that the presence of a discharge of a first polarity causes the ESD transistor to switch on to form a further path for dissipation of a discharge.

Thus, when the ESD transistor is switched on, a low impedance current dissipation path is opened up to allow dissipation of a discharge with a first polarity. In an embodiment, the reverse path for dissipation of a discharge of a second polarity is provided by the reverse conduction capabilities of the ESD transistor in the off state.

The ESD transistor may be any type of transistor, for example, field effect transistors (FETs) such as MOSFET, HEMT, or IGBT transistors using a range of materials, for example, Si, GaN or SiC.

In a further embodiment, a diode is provided in parallel with the ESD transistor to allow a current dissipation path for the dissipation of discharge with a second polarity. The diode may be intrinsic to the ESD transistor, for example, a body diode is intrinsic to a MOSFET or the diode may be separately provided. For a GaN FET, the diode (if present) will be provided separately in parallel with the FET. The reverse conduction capabilities of a GaN may also be relied upon instead of the diode.

Dissipation of a discharge with a second polarity in addition to the path through the ESD diode and thus current can flow in both directions through the ESD component when the ESD transistor is switched on.

A current sensing transistor, commonly known as sense transistor or sense FET, is an example of such a device that can perform the current-sensing function. Sense transistors can be configured as a smaller part of a large, main current carrying semiconductor device, such as a conventional transistor device (main transistor/FET).

During normal operation of the current sensing circuitry, sense transistor samples an accurate replica current from the semiconductor device, which may be a smaller fraction of the current of the semiconductor device. This may be accomplished by designing a transistor current ratio between the replica sense transistor M_{LS} and the main transistor M_{L} accordingly, e.g. 1:Nₛ (e.g., Nₛ=100,000).

However, due to its tiny size, sense transistor is susceptible to damage caused by electrostatic discharge (ESD), especially ESD occurring at the sense source pin. Hence, there is a need to protect sense transistor from ESD damage.

The above embodiment provides an ESD protection component which is configured such it can allow dissipation of the current caused by electrostatic discharge of either polarity. The above embodiment increases ESD robustness of the current-sensing component by providing double polarity protection to the current-sensing component from damage caused by ESD. The ESD protection provides two low inductance paths to allow the ESD current to dissipate.

In an embodiment, the power switching component comprises a transistor (which will be termed a "main FET" or main transistor) and the current sensing component comprises a sense transistor.

The sense transistor may be any type of transistor, for example, field effect transistors (FETs) such as MOSFET, HEMT, or IGBT based technologies using a range of materials, for example, Si, GaN or SiC. The main transistor may be any type of transistor, for example, field effect transistors (FETs) such as MOSFET, HEMT, or IGBT based technologies using a range of materials, for example, Si, GaN or SiC.

In an embodiment, the ESD transistor, sense transistor and main transistor are of the same type, i.e. all MOSFETs or all GaNs etc.

The ESD transistor comprises a gate and the ESD transistor gate may be configured such that the ESD transistor switches "on" to allow current flow when an electrostatic discharge of a first polarity is applied. Thus, an ESD of a first polarity causes the discharge to dissipate in a first direction in a first low inductance loop that includes the ESD transistor and an ESD of a second polarity, opposite to the first polarity causes the discharge to dissipate in a second direction in a second low inductance loop that includes the body diode of the ESD transistor.

In an embodiment, the main transistor has a first and second terminal and the sense transistor has a first and second terminal, the first terminals being one of a source and drain and the second terminal being the other of a source and drain, the main transistor and sense transistor having their first terminal connected to a common first terminal and the second terminal being connected by a connection path comprising a resistor. The provision of the resistor assists in the dissipation of ESD. However, it also allows the sense transistor and main transistor to both be tested by connecting to the same second terminal since the second terminal of the main transistor and sense transistor are connected. This reduces the likelihood of damage to the sense transistor via connecting separately to a sense source terminal during testing.

In the above embodiment, the gate of the ESD transistor is connected with a terminal of the main transistor. In the configurations described herein, it is connected to the source terminal. To achieve this, in an embodiment, the gate of the ESD transistor is connected to the connection path comprising the resistor. Thus, when a potential applied to the second terminal of the main transistor is equal to the potential applied to the second terminal of the sense transistor, there is no signal applied to the gate of the ESD transistor and the ESD transistor is off and allows no current to flow through the channel of the ESD transistor. However, when an ESD of a first polarity is applied to the second terminal of the sense transistor, the gate of the ESD transistor is switched on allowing current to flow through the channel of the ESD.

In a further embodiment, the gate of the ESD transistor is connected directly to a terminal of the main transistor. This allows the gate of the transistor to be switched on when an ESD of a first polarity occurs at the second terminal of the sense transistor.

In an embodiment, the main transistor comprises a plurality of component transistor (or cells) arranged in parallel and the sense transistor comprises at least one of the component transistors, the number of component transistors in the main transistor being larger than the number of component transistor in the sense transistor. The ESD transistor may also comprise a plurality of the component transistor, the number of component FETs in the ESD transistor being larger than the number of component transistors in the sense transistor. For example, the main transistor has 100,000 component transistors , whereas the sense transistor has just one component transistor. In an embodiment, the ESD transistor will have from 10 to 1000 component transistors, for example 100 component transistors.

The component transistors of the ESD transistor may be of the same type as the component transistor in the sense transistor. This has particular advantages as the same layer structure can be used for the sense transistor and ESD transistors and allows ESD protection to be implemented using the existing fabrication framework while avoiding the need for extra process masks during the lithographic processing of the semiconductor device. Further, to achieve better layout matching, the implementation of sense transistor unavoidably introduces some dummy transistors which could be re-designed as the ESD transistor.

Also, the above described resistor in the connection path "ESD resistor" can be also realized in a dummy area. As a result, the ESD resistor and transistor occupy negligible chip area.

In a further embodiment, the ESD protection component comprises a plurality of ESD transistors in parallel with one another.

The ESD resistor may also be used independently of the ESD transistor. Therefore, in a second aspect, a semiconductor device is provided comprising:
a power switching component comprising a main transistor configured to control the flow of current through a load path; and
a current sensing component comprising a sense transistor configured to sense the current flow through the load path,
wherein the main transistor has a first and second terminal and the sense transistor has a first and second terminal, the first terminal of the main transistor and sense transistor being one of a source and drain and the second terminal of the main transistor and sense transistor being the other of a source and drain, the main transistor and sense transistor having their first terminal connected to a common first terminal and the second terminal being connected by a connection path comprising a resistor.

The resistor may have a resistance of between 1kΩ - 1MΩ, in further embodiments between 50kS2 and 500kS2.

The above resistor may also be used in combination with the above described ESD protection component that is provided in parallel with the current sensing component, wherein the ESD protection component comprises an ESD transistor, the ESD transistor having a gate which is connected to a discharge path such that the presence of a discharge of a first polarity causes the EST transistor to switch on to form a further path for dissipation of a discharge.

An example size of the ESD transistor (e.g., 0.008mm²) is 100 times larger than the sense transistor while 1000 times smaller than the main transistor (e.g., 8mm²). In some examples, the layout size of the ESD transistor is only 0.1% of the total die size. The ESD transistor is more efficient at dissipating ESD energy than the ESD resistor. This is at least partially achieved as the ESD transistor has an intrinsic reverse diode or reverse conduction capabilities.

Thus, the present invention provides the described advantages within the existing fabrication framework and avoids the need for extra process steps since the ESD protection component can be fabricated using the same transistors as the sense transistor and main transistor.

The embodiments described herein are suitable for applications including SPS, DrMOS, OrGaN, hot swap MOSFET, bidirectional switch, smart MOS, etc. The semiconductor device with sense FET concept could be also based on MOSFET, GaN, SiC, or IGBT technologies.

The embodiments described herein can be provided on the same semiconductor die as a monolithic integrated circuit.

The accompanying drawings and descriptions thereof, provided below, disclose various semiconductor devices. The components and terminals of the disclosed devices described herein are connected to each other via conductive tracks. The conductive tracks are able to carry current between the components and terminals.

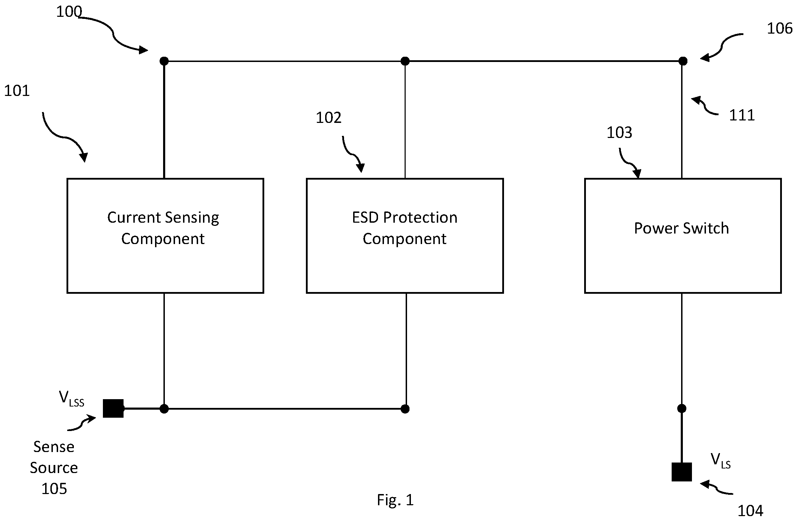

Fig. 1 is a very high level illustration of an electrostatic discharge (ESD) protection component 102 in accordance with an embodiment.

The ESD protection component 102 is provided as part of a semiconductor device 100. In Fig. 1, the semiconductor device 100 comprises a power switch, which in this embodiment is power transistor 103. The power transistor 103 is configured to be switch in load path 111. Load path 111 is used to deliver current between a main source terminal 104 to a main drain terminal 105.

A current sensing component 101 is provided in a sense path between the main drain 106 and a sense source 105. The current sensing component 101 allows the current flowing through the load path 111 to be measured since the current flowing through the sense path (replica current) will be proportional to the current through load path 111 if the sense source V_{LSS} has the same voltage level as the power switch source V_{LS}, V_{LSS} ≈ V_{LS}.

The above is an example of a current mirror mechanism.

Measurement of the current flowing through the sense path via the sense source terminal can sometimes cause an electrostatic discharge at sense source terminal. The current sensing component 101 is smaller than the power transistor and therefore is prone to damage due to the electrostatic discharge.

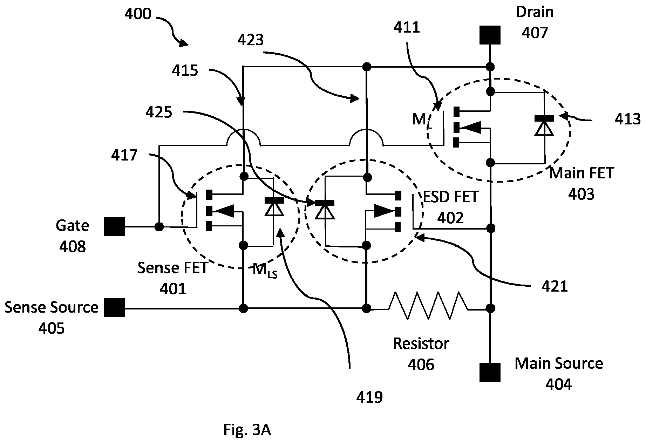

An electrostatic discharge (ESD) protection component 102 is provided in parallel with the current sensing component. The ESD protection component provides two pathways for dissipation of a discharge, the first pathway due to current flow through the ESD protection component in a first direction and the second pathway due to current flow through the ESD protection component in a second direction which is opposite to the first direction. Electrostatic discharge can be positive or negative. The function of the ESD protection component will be described with reference to FIG. 3A.

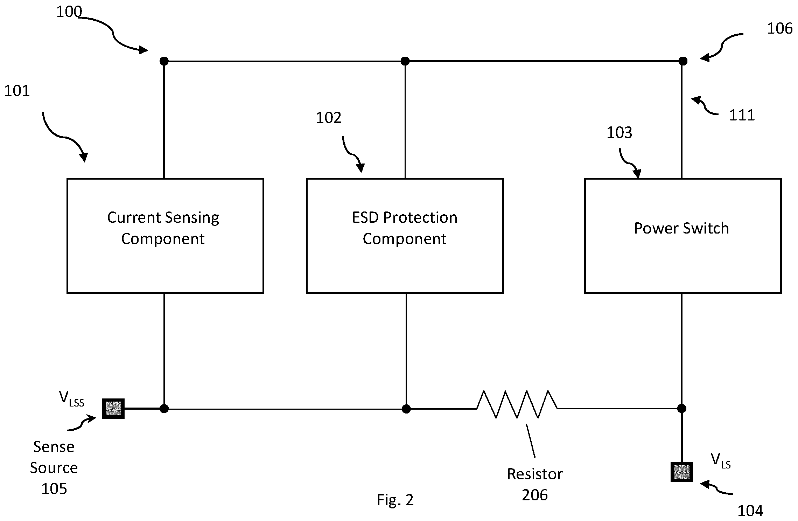

FIG. 2 illustrates a variation on the device of FIG. 1 where a pathway is formed between the sense source terminal and the main source terminal. This is illustrated by resistor 206.

Resistor 206 has two functions:
(i) It aids the dissipation of an ESD current that occurs at the sense source terminal; and
(ii) It allows the current sensing component 101 to be tested by just connecting to the main source and main drain i.e. without using the sense source terminal. This reduces the likelihood of damage to the current sensing component via connecting to the sense source terminal during testing.

Semiconductor device 100 includes an ESD resistor 206. The ESD resistor 206 is connected in series across the main source 104 and sense source 105. The ESD resistor 206 can represent one resistor, or can represent a plurality of resistors connected in combination to achieve a desired resistance value. The plurality of resistors can be connected in series and/or parallel with each other.

The ESD resistor 206 is designed or configured to have a certain resistance value. In some examples, the resistance value of the resistor 206 is between 1 kΩ -1 MΩ, inclusive.

FIG. 3A is a schematic of a semiconductor device 400 in accordance with an embodiment. The device 400 is of the same structure as device 100 described with reference to Fig. 2. However, examples of the devices which may be used for the power switching component 103, the current sensing component 101 and the ESD protection component 102 of FIGs. 1 and 2 are shown.

In this embodiment, the power switching component is as power transistor 403. The power transistor 403 is a FET which will sometimes be termed as main FET. The main FET 403 comprises gate 411 which is used to switch the channel of main FET 403 between an 'on' state' and an 'off' state. In the 'on' state, current flows from the main source terminal 404 to the main drain terminal 407. The gate 411 of the main FET 403 is connected to gate terminal 408 through which control of the main FET gate 411 is achieved. The main FET 403 also has a source and a drain, the channel of the FET provided between the source and the drain of the FET. The source of the main FET 403 being electrically connected to main source 404 and the drain of the FET being electrically connected to drain 407.

A body diode 413 is provided in parallel with the main FET. The body diode allows current flow in first direction from the main source 404 to the drain 407 and preventing current flow in the opposite direction. In Fig. 3A, the main FET is shown as a single FET. However, in practice, there may be a plurality of FETs connected together in parallel which form the main FET. A diode is connected in parallel with each FET. The plurality of FETs which form main FET 403 will be termed "component" FETs or cells. The diode may be a body diode which is intrinsic to each FET (as in the case with MOSFETs) or be provided separately.

The main diode may be an intrinsic diode of the main FET (for example as provided in MOSFET technology) or be provided in addition to the main FET, for example a GaN FET does not typically have an intrinsic diode and so a diode will be provided in parallel with the main FET. In an embodiment, a plurality of main FETs may be provided in parallel with one another and a diode is provided in parallel with the plurality of main FETs. In other words, the number of main diodes does not have to match the number of main FETs. For example, a plurality of GaN FETs may be provided in parallel with a single silicon based diode.

In the embodiment of Fig. 3A, the current sensing component is also a FET 401 which will be termed sense FET 401. Sense FET 401 is provided in current sense path 415. Sense FET 401 has a gate 417 which is used to switch the channel of Sense FET 401 between an 'on' state' and an 'off' state. In the 'on' state, current flows from the sense source terminal 405 to the main drain terminal 407. The gate 417 of the sense FET 401 is connected to gate terminal 408 through which control of the sense FET gate 417 is achieved. In this embodiment, both the gate 417 of the sense FET 401 and the gate 411 of main FET 403 are tied to the same gate terminal 408.

The Sense FET may be of the same technology type as the main FET 403, this has advantages as it can provide efficiencies in the processing since the same processing steps can be used for both the Sense FET and main FET. The sense FET and main FET may be monolithically integrated. The sense FET and main FET may both be based on a range for different technologies, for example MOSFET, GaN, SiC, and IGBT. However, in other embodiments, the sense FET 401 may be based on different semiconductor technologies (e.g., MOSFET, GaN, SiC, and IGBT) to the main FET.

The sense FET 401 also has a source and a drain, the channel of the sense FET being provided between the source and the drain of the FET. The source of the sense FET 401 being electrically connected to sense source 405 and the drain of the sense FET being electrically connected to drain 407. A sense FET diode 419 is also provided in parallel with the sense FET 401. The sense FET diode 419 being configured to allow current flow in the first direction from the sense source 405 to the drain 407.

The configuration of the sense FET 401 and the main FET 403 forms a current mirror arrangement where the current flowing through the sense path 415 is a proportion of the current flowing through the load path. The proportion of the current between the sense path and the load path being set by the relative size of the main FET 401 and the sense FET 401. If the main FET 403 and sense FET 401 comprise component transistors, then the ratio between the numbers of component transistors in the main FET 403 and the sense FET 401 provides the current ratio.

The ESD protection component is also realized by an FET which is ESD FET 402. The ESD FET is provided in parallel with the sense FET 401. The ESD FET 402 is provided in a discharge path 423. The ESD FET 402 comprises gate 421 which is used to switch the channel of ESD FET 402 between an 'on' state' and an 'off' state. In the 'on' state, current flows through the channel of the ESD FET. The gate 421 of the ESD FET 402 is connected to main FET source 404 such that the main FET source 404 acts as a control signal for ESD FET 402. The ESD FET 402 also has a source and a drain, the channel of the ESD FET provided between the source and the drain of the ESD FET. The source of the ESD FET 402 being electrically connected to sense source 405 and the drain of the ESD FET being electrically connected to drain 407.

The ESD FET 402 may be of the same technology type as the main FET 403 and sense FET 401, this has advantages as it can provide efficiencies in the processing since the same processing steps can be used for both the ESD FET, Sense FET and main FET. The ESD FET, sense FET and main FET may be monolithically integrated. The ESD FET, sense FET and main FET may both be based on a range for different technologies, for example MOSFET, GaN, SiC, and IGBT. However, in other embodiments, the ESD FET, may be based on different semiconductor technologies (e.g., MOSFET, GaN, SiC, and IGBT) to the main FET and the sense FET 401.

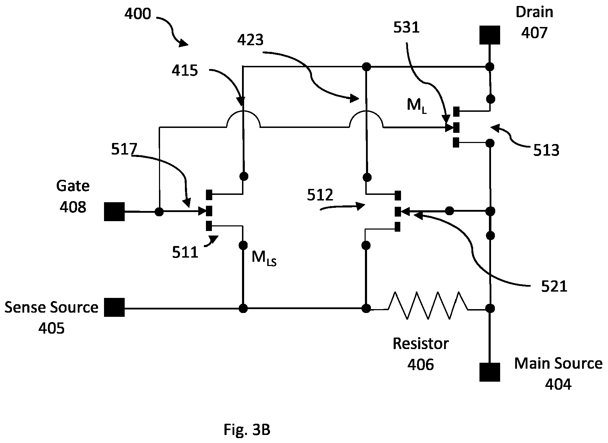

A diode 425 is provided in parallel with the ESD FET 402. The ESD FET diode 425 allows current flow in first direction from the sense source 405 to the drain 407 and preventing current flow in the opposite direction. In Fig. 3, the ESD FET 402 is shown as a single FET. However, in practice, there may be a plurality of FETs connected together in parallel which form the ESD FET. The plurality of FETs which form main FET 403 will be termed "component" FETs or cells. A diode is provided in parallel with each component FET.

The ESD diode may be an intrinsic diode of the ESD FET (for example as provided in MOSFET technology) or be provided in addition to the ESD FET, for example a GaN FET does not typically have an intrinsic diode and so a diode will be provided in parallel with the ESD FET. In an embodiment, a plurality of ESD FETs may be provided in parallel with one another and a diode is provided in parallel with the plurality of ESD FETs. In other words, the number of ESD diodes does not have to match the number of ESD FETs. For example, a plurality of GaN FETs may be provided in parallel with a single silicon based diode.

In normal operation, the ESD FET operates in an off state and shows no impact on current-sensing accuracy during the steady state as the sense source voltage equals the main source (V_{GS}__{ESD} = 0V, where V_{GS}__{ESD} is the gate voltage on ESD FET gate 421).

Sense FET 401 performs the current sensing function based on the operation principle of the current-mirror mechanism. As detailed above, an accurate replica current is obtained when the sense source voltage equals the main source voltage. As a result, during normal operation, there is no potential difference across the gate and source of the ESD FET 402 (V_{GS}__{ESD} = 0V). Thus, the ESD FET 402 operates in an off state and shows no impact on current-sensing accuracy during the steady state. When the ESD FET 402 is in an off state, the ESD FET 402 does not conduct current.

The component FETs of the sense FET, main FET and ESD FET may be of the same type. However, the number of component FETs in the sense FET and main FET will be different. For example, the sense FET may comprise one or more FETs connected in parallel, the ESD FET may comprise a larger number of FETs in parallel than the number of FETs in the sense FET. For example, the ESD FETs may comprise at least 2, 5, or 10 times the amount of FETs than those in the sense FET. The main FET may comprise a larger number of FETs in parallel than the number of FETs in the ESD FET. For example, the main FETs may comprise at least 2, 5, or 10 times the amount of FETs than those in the ESD FET. In an embodiment, the main FET has 100,000 component FETs, whereas the sense FET has a low number of component FETs, for example 1, 2 to 10. In an embodiment, the ESD FET will have from 10 to 1000 component FETS, for example 100 component FETs.

The use of the same type of component FETs for the sense FET, ESD FET and main FET simplifies the fabrication of the device since the same layer structure is required for the sense FET, ESD FET and main FET.

The semiconductor device 400 further includes an ESD resistor 406 which is an example of resistor 206. ESD resistor 406 is connected in series across the main source 404 and sense source 405, as shown in Fig.3. The ESD resistor 406 can represent one resistor, or can represent a plurality of resistors connected in combination to achieve a desired resistance value. The plurality of resistors can be connected in series and/or parallel with each other.

Fig. 3B is a variation on the device of Fig. 3A. The device of Fig. 3A is suited to the use of FETs with intrinsic body diodes, for example, MOSFETs. The transistors in the circles of Fig. 3A can be replaced with transistors of other types. Fig. 3B shows a variation where transistors are used without an additional diode, this device is suited to the use of transistors such as GaN FETs which do not have an intrinsic body diode. To avoid any unnecessary repetition, like reference numerals will be used to denote like features. The ESD protection component is provided by GaN FET 512. The GaN FET has a channel, conduction through which is controlled via a gate 521. There is no body diode in GaN 512. The sense transistor is provided by GaN FET 511. The GaN FET 511 has a channel, conduction through which is controlled via a gate 517. There is no body diode in GaN 511. The main transistor is provided by GaN FET 513. The GaN FET has a channel, conduction through which is controlled via a gate 531. There is no body diode in GaN 513.

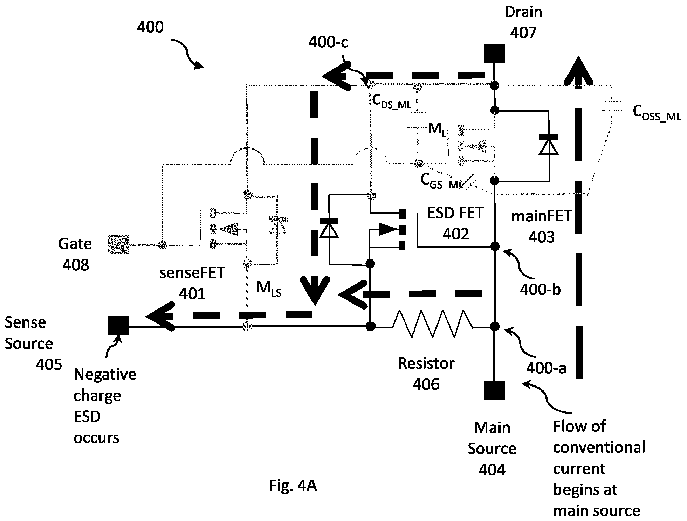

The operation of the ESD protection will now be described with reference to Figs. 4A to 4B. The same reference numerals will be used as those described with reference to Fig. 3. Fig. 4A is a circuit diagram of the semiconductor device 400 illustrating the flow of current and operation of the ESD FET 402 and ESD resistor 406 when a negative ESD occurs at the sense source 405. In this scenario, a negative sense source 405 voltage (-V_{LSS}) is produced with respect to the main source 404 (V_{LS}). Thus, the flow of conventional current begins from the main source 404. The path of the current flow is illustrated with the help of arrows in Fig. 4A. The circuit components which form the primary part of the discharge path are shown in black and the other components are shown in grey. Heavy dotted arrows show the direction of charge flow.

Upon reaching junction 400-a, the current is divided and some of the current is dissipated by the ESD resistor 406. Furthermore, the ESD FET 402 is turned on due to a positive V_{GS}__{ESD} > V_{TH}. The ESD FET 402 is configured/designed to have a low R_{DSON} (e.g. 1 Ω). The body diode of the main FET 403 is configured in a forward bias position, thus allowing current to flow through the diode with ease. The main FET 403 is off so little to no current will flow through the channel of main FET 403. In an embodiment, the diode and channel of the FET are monolithically integrated.

The current that is divided and diverted from the primary current path at junctions 400-a and 400-b avoids the sense FET 401 and is dissipated. The remaining current that passes through the body diode of the main FET 403 then reaches junction 400-c. Here, the current will predominantly flow along the path of least impedance, i.e. through the "on" ESD FET 402. In an embodiment, the resistance of ESD FET 402 may be 100 times smaller than the resistance of sense FET 401.

Thus, a low-impedance path consisting of the main FET 403 body diode and ESD FET 402 is generated in response to negative ESD occurring at the sense source 405. An alternative path consisting of the resistor 406, ESD FET 402, and the body diode of main FET 403 is thus created, through which the ESD current can flow. The ESD energy can be quickly dissipated on this low-impedance path, thus protecting sense FET 401.

Thus, the ESD FET 402 is able to protect sense FET 401 from damage caused by negative ESD.

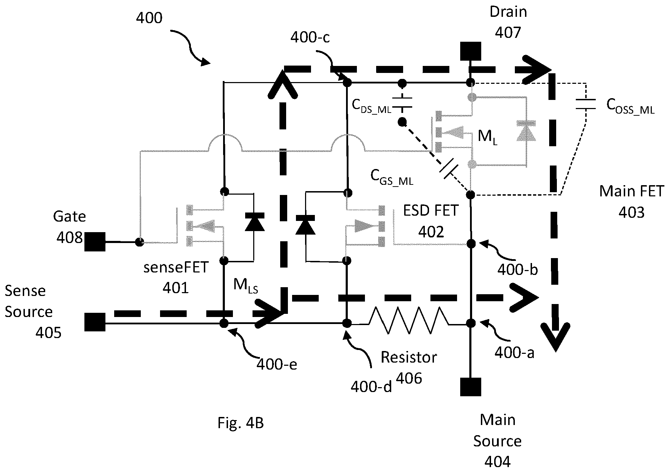

Fig. 4B is a circuit diagram of the semiconductor device 400 illustrating the flow of current and operation of the ESD FET 402 and ESD resistor 406 when a positive ESD occurs at the sense source 405. In this scenario, a positive sense source 405 voltage (+V_{LSS}) is produced with respect to the main source 404 (V_{LS}). Thus, the flow of conventional current begins from the sense source 405. The path of the current flow is illustrated with the help of arrows in Fig. 4B.

Upon reaching junction 400-e, the current flows through both the diode 419 of the sense FET in the sense path and the diode 425 of the ESD FET in the discharge path.

The body diode of the ESD FET 402 and the diode of the sense FET 401 transfers the energy to the main FET, and the large main FET output capacitance Coss will absorb the energy. Thus, the ESD FET 402 is able to protect senseFET 401 from damage caused by positive ESD. Furthermore, as a consequence of the ESD FET 402 being connected in parallel with the sense FET 401, the current flowing through the sense FET 401 branch will be divided, thus reducing the amount of energy passing through the sense FET 401 body diode.

Thus, as shown in Figs 4A and 4B, the ESD protection allows dissipation of both a negative and a positive ESD at the sense source. In the configuration shown in Fig. 4B, for a positive ESD, the dissipation path is through the diode of the discharge path in a first direction. For a negative ESD, the current flows through the discharge path in the opposite direction. It achieves this by configuring the device such that the negative ESD allows a signal to be applied to the gate of the ESD FET to allow the ESD FET to switch on.

In some implementations, the main FET 403 does not have a body diode, and instead relies on internal parasitic capacitors (Coss, C_{GS}, and/or C_{GD}) to absorb ESD energy which are illustrated in FIGs. 4A and 4B. In this implementation, the capacitors can be large enough to absorb the ESD energy.

The resistor 406 provides further protection to sense FET 401 from ESD occurring at the sense source 405 by aiding dissipation. However, the resistor 406 provides additional ESD protection advantages. Specifically, the ESD resistor 406 protects the sense source 405 from ESD introduced by charged device testing and reduces device wafer-level testing time. In more detail, as the main source 104 and sense source 105 are separated (i.e. not connected) in Fig. 1, the power transistor 103 and the current sensing component 101 need to be tested independently. However, with the addition of the resistor 406, the main FET 403 and the sense FET 401 can be tested simultaneously including items of BVOX, BVDSS, and leakage currents lOSS & IGSS, etc. This is because the voltage drop across resistor 406 (e.g., 50mV) due to the small sense FET 401 gate leakage current (e.g., 1uA) is negligible in comparison with the large BVOX voltage (e.g., 27V). As a result, the testing time gets substantially reduced.

An example size of ESD FET 402 is 100 times larger than sense FET 401 while being 1000 times smaller than main FET 403. For example, if the size of ESD FET 402 is 0.008 mm², then main FET 403 is of size 8 mm².

As the two devices can be tested simultaneously, the testing device such as a wafer probe does not need to make contact or touch the sense source 405 pin. This removes the risk of ESD introduction to the pin. Thus, the sense source 405 is further protected from ESD damage. The sense FET is small and therefore it has tiny leakage currents which are difficult to accurately measure. The provision of resistor 206., 406 means that the challenge of measuring the <1nA leakage current of the small sense FET is avoided. Further, as the initial voltage of the sense source 405 equals the main source 404, this is beneficial to minimize the settling time of the current sensor circuits on the gate driver IC during startup.

Furthermore, like the ESD FET 402, the introduction of the ESD resistor 406 does not impact the current sensing accuracy of the sense FET 401 configuration during normal operation. During the steady state, the same drain, gate, and source voltages are achieved for the sense FET 401 and main FET 403. As a result, there is little to no voltage drop across the resistor 406. Thus, almost no current passes through the resistor 406 at a steady state.

Figs. 4A and 4B described the discharge path when the ESD FET has a body diode 425. For the GaN implementation of Fig. 3B, in an embodiment, the reverse conduction capabilities of a GaN are relied upon to allow dissipation of the charge in the direction shown in Fig. 4B.

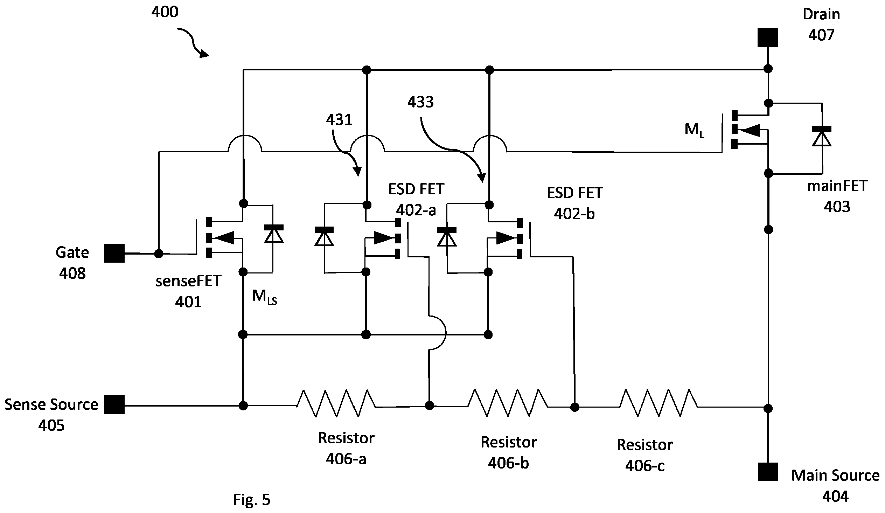

Fig. 5 is a circuit diagram of a semiconductor device 400 showing an example configuration of multiple ESD transistors and resistors in accordance with an embodiment. To avoid any unnecessary repetition, like reference numerals will be used to denote like features. Here, the ESD protection component 102 comprises two ESD FETs 402-a, 402-b with diodes.

The ESD protection component comprises a first ESD FET 402-a connected in parallel across sense FET 401 in a first discharge path 431 and a second ESD FET 402-b connected in parallel across sense FET 401 in a second discharge path 433. Both the first ESD FET 402-a and the second ESD FET 402-b are provided with body diodes in parallel to the ESD FETs.

Furthermore, in addition a first resistor 406-a, second resistor 406-b and a third resistor 406-c are provided and connected in series between the sense source 405 and the main source 404. The gate of the first ESD FET 402-a is connected to a point between the first resistor 406-a and the second resistor 406-b. The gate of the second ESD FET 402-b is connected to a point between the second resistor 406-b and the third resistor 406-c. The operation of the first and second ESD FETs is the same as described above for the single ESD FET described with respect to Figs 4A to 4B in that their gates respond to an ESD provided at the sense source terminal 405.

While Fig. 5 illustrates a specific combination of ESD FETs and resistors, the skilled person appreciates that other combinations are possible. In other embodiments, a plurality of ESD FETs and ESD resistors in various combinations are provided in the semiconductor device 400. The purpose of Fig. 5 is to provide an example framework for how these multiple ESD devices are connected with each other, while providing effectively the same ESD protection as the semiconductor device 400 of Fig. 3.

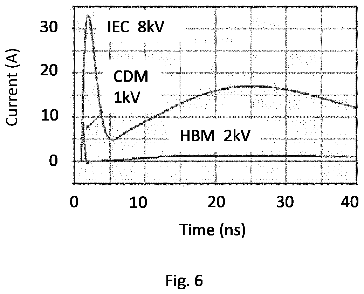

Fig. 6 is a graph showing ESD profiles. To verify the performance of the proposed ESD FET and resistor, simulations based on Fig. 6 ESD test were conducted using the charged device model (CDM) and human body model (HBM).

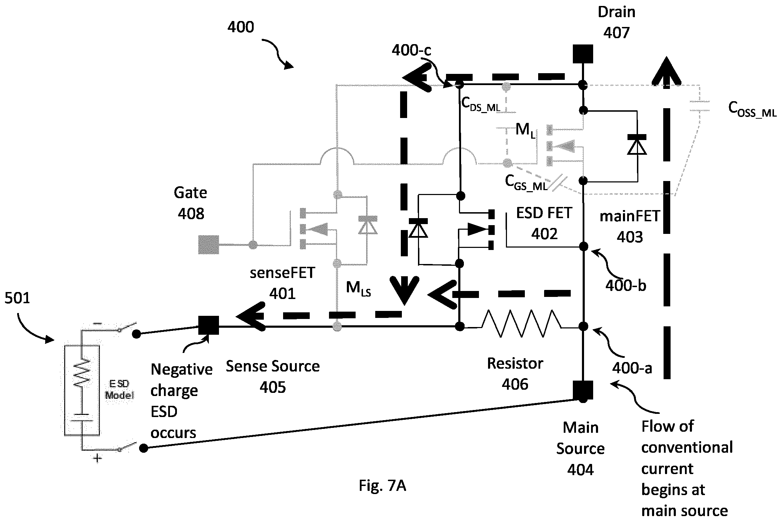

Fig. 7A is a circuit diagram illustrating a simulation test bench with a negative sense source voltage (-V_{LSS}) with respect to the main source (V_{LS}). The semiconductor device is the same as that shown in Fig. 4A, like reference numerals are used to denote like features. The negative ESD is simulated using model 501. The current flow during ESD is the same as that described with reference to Fig. 4A.

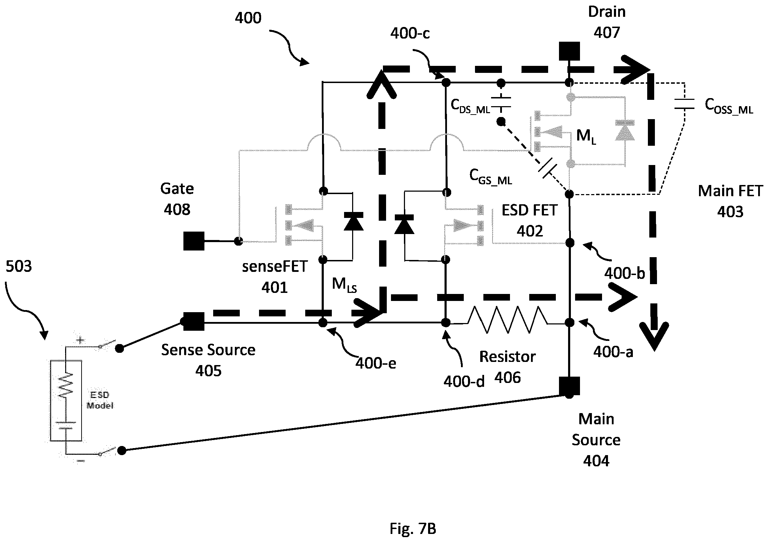

Fig. 7B is a circuit diagram illustrating a simulation test bench with a positive sense source voltage (+V_{LSS}) with respect to the main source (V_{LS}). The semiconductor device is the same as that shown in Fig. 4B, like reference numerals are used to denote like features. The positive ESD is simulated using model 503. The current flow during ESD is the same as that described with reference to Fig. 4B.

Both CDM and HBM simulations are conducted and tabulated in Table I. The table shows that sense FET suffers from ≥200V CDM and HBM issues without ESD protections. However, these issues are mitigated when the ESD FET and resistor are provided.

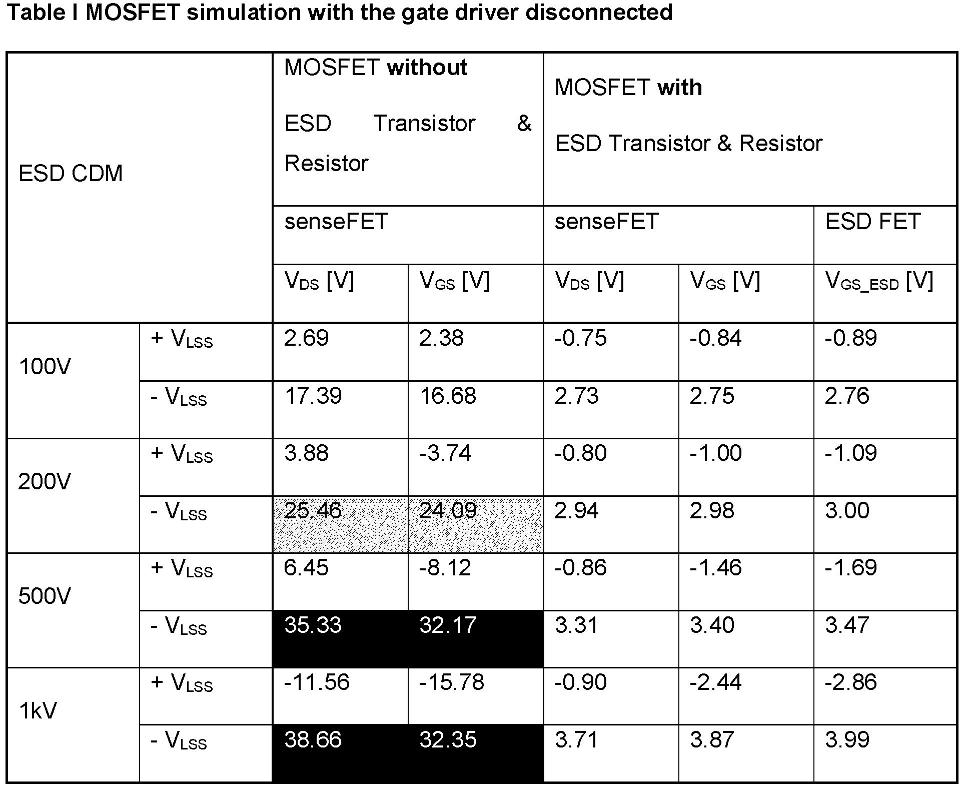

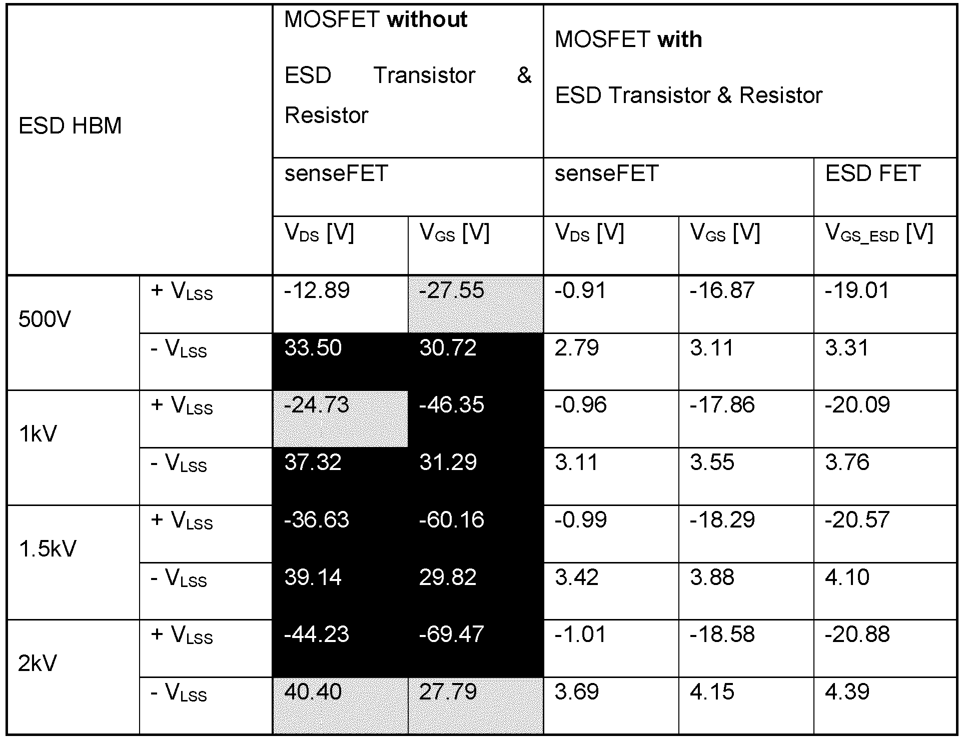

In more detail, Table 1 shows experimental results of voltage readings taken during testing of the sense FET with and without the ESD protection component as described with reference to Figs. 1 to 4B.

As shown in Table 1, in the absence of the ESD FET, a large drain voltage V_{DS} and gate voltage V_{GS} is measured for sense FET, as shown in columns 1 and 2 of Table 1.

Columns 3 and 4 of Table 1 show the impact of the ESD FET on the measured drain voltage V_{DS} and gate voltage V_{GS} of senseFET. In the case of negative ESD, the charge has an alternative path of lower impedance to flow through, resulting in substantially lower measurements of the sense FET drain voltage V_{DS} and gate voltage V_{GS}. Similarly, in the case of positive ESD, the current is divided between the body diode of sense FET and the body diode of ESD FET, resulting in lower measurements of the sense FET drain voltage V_{DS} and gate voltage V_{GS}. However, it is possible that negligible or trace amounts of voltages may still be measured across sense FET, for example, less than 20V.

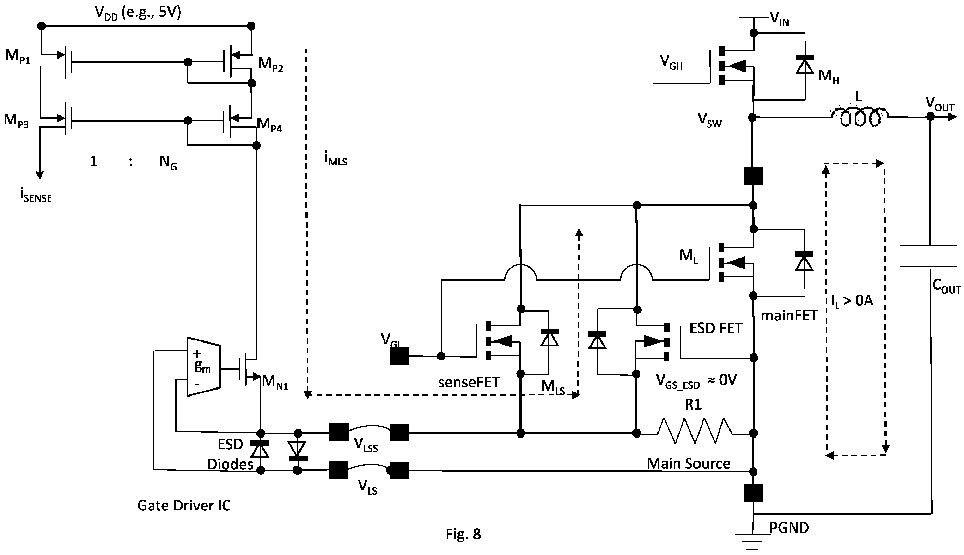

Fig. 8 is a circuit diagram illustrating a simulation test-bench with a gate driver connected.

The above described semiconductor device may be used with a gate driver IC which offers ESD protection blocks for each I/O pin. Such an arrangement is shown in Fig. 8. To verify ESD performance of the semiconductor device of Figs. 1 to 4B with the gate driver IC as illustrated in Fig. 8, simulations were conducted and the results are summarized in Table II which shows the sense FET characteristics for 1kV CDM and 2kV HBM.

**Table II MOSFET simulation with the gate driver connected**

| ESD | | Gate driver IC & MOSFET **with** ESD Transistor & Resistor | | |
|---|---|---|---|---|
| | | senseFET | | ESD FET |
| | | V_{DS} | V_{GS} | V_{GS}__{ESD} |
| 1kV CDM | + VLSS | -0.83 | -1.18 | -1.33 |
| | - V_{LSS} | 2.89 | 2.93 | 2.95 |
| 2kV HBM | + V_{LSS} | 3.41 | -4.52 | -5.28 |
| | - V_{LSS} | 3.12 | 3.16 | 3.20 |

Practically, to achieve better layout matching, the implementation of sense FET unavoidably introduces some dummy transistors which could be re-designed as the ESD transistor. Similarly, the ESD resistor can be also realized in a dummy area. As a result, the ESD resistor and transistor occupy negligible chip area.

The above description has focused on the use of the discharge FET to allow dissipation of a ESD. However, the use of the resistor shown as 206, 406 in Figs 2 and 3 when used on its own also provides advantages.

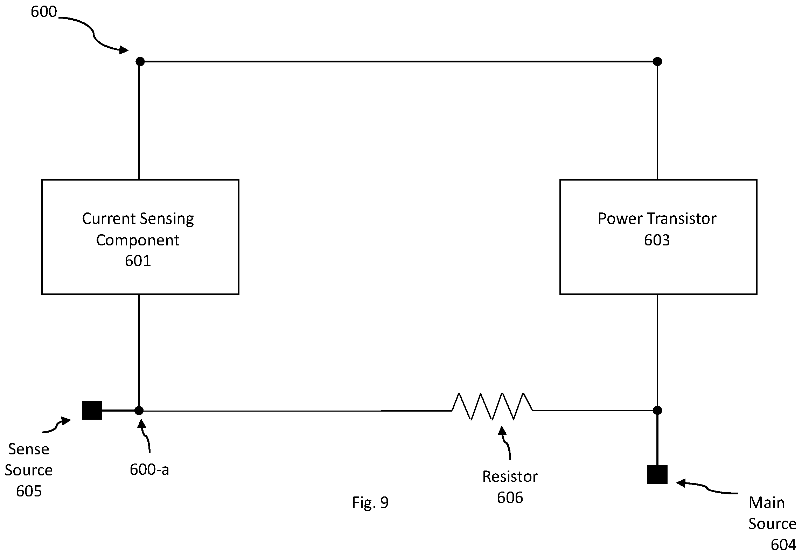

Fig. 9 is a schematic illustrating an ESD resistor 606 in accordance with an embodiment without a discharge FET. Semiconductor device 600 is similar to the semiconductor device 200 of Fig. 2. Therefore, ESD resistor 606 is an example of ESD resistor 206. However, semiconductor device 600 differs from semiconductor device 200 in that semiconductor device 600 is provided without the ESD protection component 202. Thus, in the present embodiment, the resistor 606 is primarily responsible for ESD protection of the sense source 605.

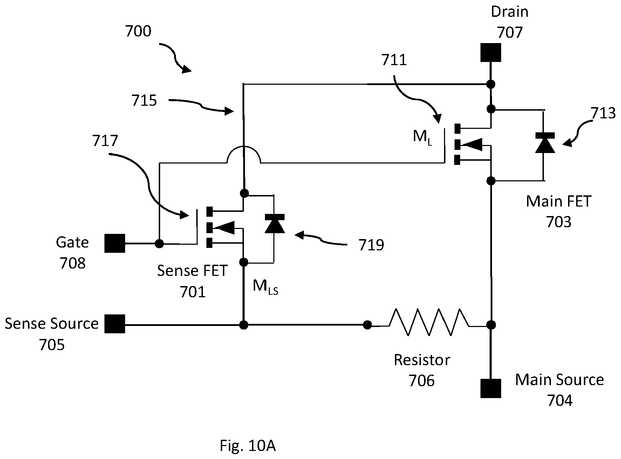

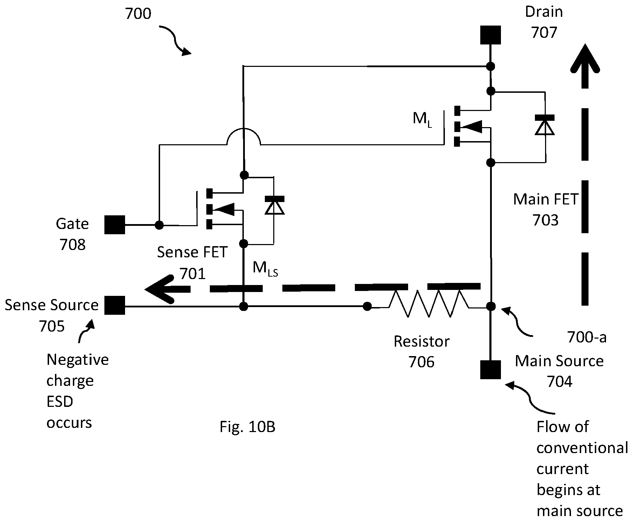

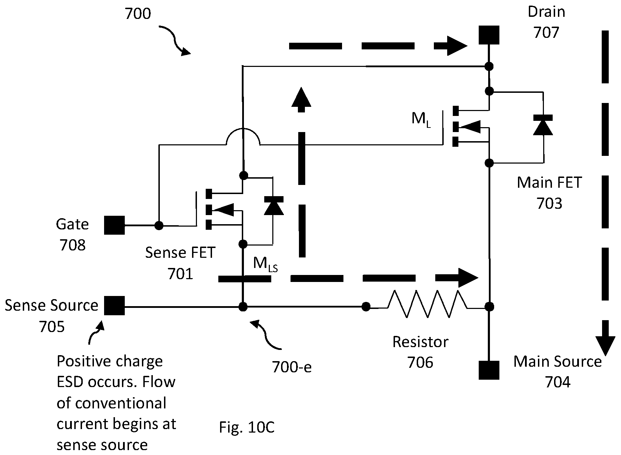

The ESD resistor 606 is connected in series across the main source 604 and sense source 605, as shown in Fig. 10. The ESD resistor 606 can represent one resistor, or can represent a plurality of resistors connected in combination to achieve a desired resistance value. The plurality of resistors can be connected in series and/or parallel with each other.

The resistor 606 protects the current sensing component 601 from ESD damage by providing an alternate path for the current to flow, resulting in negligible or no current caused by ESD to flow through the current sensing component 601.

In the case of negative ESD occurring at the sense source 605, the resistor 606 is able to provide an alternate path for the conventional current flowing from the main source 604 to the sense source 605. The current is divided between the resistor 606 and the power transistor 603. Subsequently, owing to the high resistance values of the resistor 606, the resistor is able to dissipate the energy attributed to the current passing through it. Subsequently, owing to the high resistance of the resistor 606, a small portion of current passes through it, and hence the power dissipation on it is low. The remaining large current (i.e. the divided current that does not flow through the resistor 606) passes through the low turn-on impedance power transistor 603. The main energy is transferred outside.

In the case of positive or negative ESD occurring at the sense source 605, the resistor 606 is able to provide an alternate path for the conventional current flowing from the sense source 605 to the main source 604. After the current is divided at the junction 600-a, the remaining current passes through resistor 606. The resistor is able to dissipate the energy attributed to the current passing through it.

The resistor 606 may be configured to have at resistance value between 50 KΩ and 500 KΩ so as to ensure that a negligible amount of energy is transferred over to the current sensing component 601 in the case of both positive and negative ESD.

In addition to providing a dissipation path for ESD, the resistor 606 provides additional ESD protection advantages. Specifically, the ESD resistor 606 protects the sense source 605 from ESD introduced by charged device testing and reduces device wafer-level testing time. In more detail, as the main source 104 and sense source 105 are separated (i.e. not connected) in Fig. 1, the power transistor 103 and the current sensing component 101 need to be tested independently. However, with the addition of the resistor 606, the power transistor 603 and the current sensing component 601 can be tested simultaneously.

As the two devices can be tested simultaneously, the testing device such as a wafer probe does not need to make contact or touch the sense source 605 pin. This removes the risk of ESD due to contact with the sense source terminal 605. introduction to the pin. Thus, the current sensing component is protected from ESD damage due to contact with the sense source terminal 605.

Fig. 10A is a circuit diagram of a semiconductor device 700 showing an ESD resistor 706 in accordance with an embodiment. The semiconductor device 700 is an example of semiconductor device 600.

In this embodiment, the power switching component is as power transistor 703. The power transistor 703 is a transistor which will sometimes be termed as main FET. The main FET 703 comprises gate 711 which is used to switch the channel of main FET 703 between an 'on' state' and an 'off' state. In the 'on' state, current flows from the main source terminal 704 to the main drain terminal 707. The gate 711 of the main FET 703 is connected to gate terminal 708 through which control of the main FET gate 711 is achieved. The main FET 703 also has a source and a drain, the channel of the FET provided between the source and the drain of the FET. The source of the main FET 703 being electrically connected to main source 704 and the drain of the FET being electrically connected to drain 707.

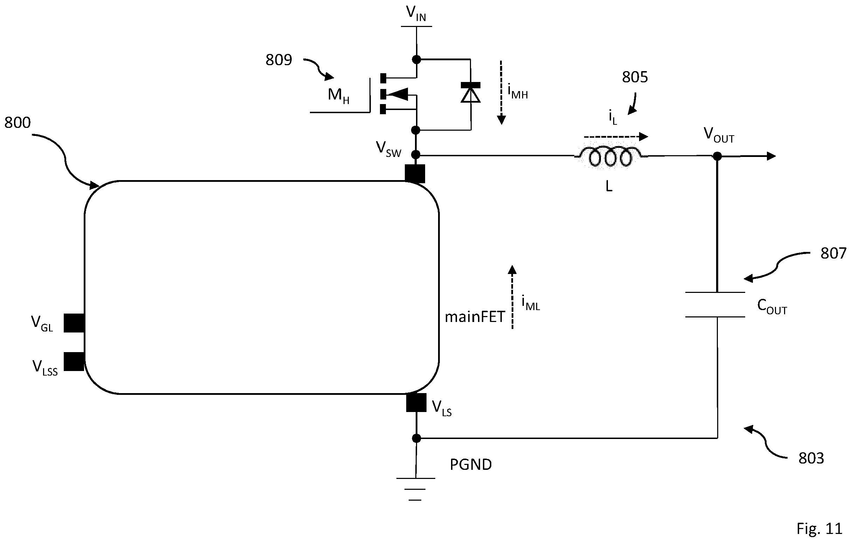

A body diode 713 is provided in parallel with the main FET. The body diode allows current flow in first direction from the main source 704 to the drain 707 and preventing current flow in the opposite direction. In Fig. 11A, the main FET is shown as a single FET. However, in practice, there may be a plurality of FETs connected together in parallel which form the main FET. A body diode is connected in parallel with each FET. The plurality of FETs which form main FET 703 will be termed "component" FETs.

In the embodiment of Fig. 10A, the current sensing component is also a transistor 701 which will, in this embodiment, be termed sense FET 701. Sense FET 701 may be based on different semiconductor devices (e.g., MOSFET, GaN, SiC, and IGBT). Sense FET 701 is provided in current sense path 715. Sense FET 701 has a gate 717 which is used to switch the channel of main FET 703 between an 'on' state' and an 'off' state. In the 'on' state, current flows from the sense source terminal 705 to the main drain terminal 707. The gate 717 of the sense FET 701 is connected to gate terminal 708 through which control of the sense FET gate 717 is achieved. In this embodiment, both the gate 717 of the sense FET 701 and the gate 711 of main FET 703 are tied to the same gate terminal 708.

The sense FET 701 also has a source and a drain, the channel of the sense FET being provided between the source and the drain of the FET. The source of the sense FET 701 being electrically connected to sense source 705 and the drain of the sense FET being electrically connected to drain 707. A sense FET diode 719 is also provided in parallel with the sense FET 701. The sense FET diode 719 being configured to allow current flow in the first direction from the sense source 705 to the drain 707.

The configuration of the sense FET 701 and the main FET 703 forms a current mirror arrangement where the current flowing through the sense path 715 is a proportion of the current flowing through the load path. The proportion of the current between the sense path and the load path being set by the relative size of the main FET 701 and the sense FET 701. If the main FET 703 and sense FET 701 comprise component transistors, then the ratio between the numbers of component transistors in the main FET 703 and the sense FET 701 provides the current ratio.

The ESD resistor 706 is an example of resistor 606 of Fig. 6 and is provided between the sense source 705 and the main source 704.

In addition to ESD protection provided by resistor 706 as described with reference to Fig. 6, the resistor 706 provides additional ESD protection advantages. Specifically, the ESD resistor 706 protects the sense source 705 from ESD introduced by charged device testing and reduces device wafer-level testing time. Referring back to Fig. 1, the main source 104 and sense source 105 are separated (i.e. not connected), the power transistor 103 and the current sensing component 101 need to be tested independently. However, with the addition of the resistor 706, the main FET 703 and the sense FET 701 can be tested simultaneously including items of BVOX, BVDSS, and leakage currents IDSS & IGSS, etc. This is because the voltage drop across resistor 706 (e.g., 50mV) due to the small sense FET 701 gate leakage current (e.g., 1uA) is negligible in comparison with the large BVOX voltage (e.g., 27V). As a result, the testing time is substantially reduced.

As the sense FET and main FET can be tested using the same terminal (main source terminal 704), the testing device such as a wafer probe does not need to make contact or touch the sense source 705 pin and connection only needs to be made to the main source terminal 704 once to test both the sense FET 701 and main FET 703. This removes the risk of ESD due to contact with the sense source terminal 705. Thus, the sense FET 701 is further protected from ESD damage. Further, the initial voltage of the sense source 705 equals the main source 704, this is beneficial during start-up. For example, if a gate driver IC of the type described with reference to Fig. 8 is used, the settling time of the current sensor circuits can be minimized during startup.

Furthermore, the introduction of the ESD resistor 706 does not impact the current sensing accuracy of the sense FET 701 configuration during normal operation. During the steady state, the same drain, gate, and source voltages are achieved for the sense FET 701 and main FET 703. As a result, there is little to no voltage drop across the resistor 706. Thus, almost no current passes through the resistor 706 at a steady state.

The flow of current in the semiconductor device 700 in response to negative ESD occurring at the sense source 705 is illustrated in Fig. 10B. In this scenario, a negative sense source 705 voltage (-V_{LSS}) is produced with respect to the main source 704 (V_{LS}). Thus, the flow of conventional current begins from the main source 704. The path of the current flow is illustrated with the help of arrows in Fig. 10B.

Upon reaching junction 700-a, the current is divided and a portion of the current is dissipated by the ESD resistor 706. Thus, the current is divided between the resistor 706 and the body diode of the main FET 703. In an embodiment, the resistor 706 is configured to have at least a particular resistance value so as to ensure that a negligible amount of energy is transferred over to the sense FET 701 via the body diode of the main FET 703. The body diode of the main FET 703 is configured in a forward bias position, thus allowing current to flow through the diode with ease. As a result, little to no current will flow through the main FET 703 itself.

The current that is divided and diverted from the primary current path at junction 700-a avoids the sense FET 701 and is dissipated. The remaining current that passes through the body diode of the main FET 703 is also dissipated quickly before reaching sense FET 701.

Thus, an alternative path consisting of the resistor 706 and the body diode of main FET 703 is thus created, through which the ESD current can flow. The ESD energy can be dissipated on this path, thus protecting sense FET 701.

Thus, the ESD resistor 706 is able to protect sense FET 701 from damage caused by negative ESD.

The flow of current in the semiconductor device 700 in response to positive ESD occurring at the sense source 705 is illustrated in Fig. 11C. In this scenario, a positive sense source 705 voltage (+V_{LSS}) is produced with respect to the main source 704 (V_{LS}). Thus, the flow of conventional current begins from the sense source 705. The path of the current flow is illustrated with the help of arrows in Fig. 10C.

Upon reaching junction 700-e, the current is divided between the sense FET 701 branch and the primary current path. However, as the body diode of the sense FET 701 is in a forward bias configuration, the current will flow through the body diode of the sense FET 701. The remaining current flows through resistor 706.

Thus, the ESD resistor 706 is able to protect sense FET 701 from damage caused by positive ESD. Furthermore, as a consequence of the resistor 706 the current flowing through the sense FET 701 branch will be divided, thus reducing the amount of energy passing through the sense FET 701 body diode.

In some implementations, the main FET 703 does not have a body diode, and instead relies on internal parasitic capacitors (Coss, C_{GS}, and/or C_{GD}) to absorb ESD energy. This is illustrated in Fig. 4B, in the example of positive ESD at the sense source 405. The capacitors may have a large enough size to absorb ESD energy.

The sense FET/transistor may also not have a body diode. For example, the sense transistor may have GaN architecture as described above in relation to Fig. 3B.

The sense transistor and main transistor may be any type of transistor, for example, field effect transistors (FETs) such as MOSFET, HEMT, or IGBT transistors using a range of materials, for example, Si, GaN or SiC. In an embodiment, the sense transistor is the same type of transistor as the main transistor.

The circuits of Figs. 10A to 10C may also be provided with an additional ESD protection component, for example a diode provided across the current sensing component to provide an additional discharge path parallel to the sense transistor in the direction shown in Fig. 10C. The additional discharge path working with the resistor to dissipate discharge.

The devices of Figs. 3A, 3B, 4A-B, 5, 7A to 7B and 10A to 10C can be considered as discrete four terminal devices, with the terminals being the main source terminal, sense source terminal, gate terminal and drain terminal. This four terminal configuration can be provided into a standby power supply (SPS) configuration. Fig. 11 depicts such an SPS with sense FET configuration with four terminal device 800 representing any of the semiconductor devices of Figs. 3A-B, 4A-B, 5, 7A to 7B and 10A to 10C.

The device 800 is provided connected with resonant circuit 803 which comprises load inductor 805 and capacitor. The resonant circuit is connected across the main source terminal and drain terminal to allow and output voltage Vₒᵤₜ to be outputted from the circuit. The input voltage being provided through switch (transistor) 809.

The circuit diagrams depicted and described in this application are provided as examples only, and the skilled person would understand that alternative circuit configurations may be designed that achieve equivalent effects.

Although described herein in relation to MOSFET transistor technology, it is provided that the ESD protection devices and methods described herein may be implemented using equivalent concepts and solutions as described in relation to MOSFETs.

Although the disclosure has been described in terms of preferred embodiments as set forth above, it should be understood that these embodiments are illustrative only and that the claims are not limited to those embodiments. Those skilled in the art will be able to make modifications and alternatives in view of the disclosure which are contemplated as falling within the scope of the appended claims. Each feature disclosed or illustrated in the present specification may be incorporated in the disclosure, whether alone or in any appropriate combination with any other feature disclosed or illustrated herein.

Many other effective alternatives will occur to the person skilled in the art. It will be understood that the disclosure is not limited to the described embodiments, but encompasses all the modifications which fall within the scope of the appended claims.

## Claims

1. A semiconductor device comprising:
a power switching component configured to control the flow of current through a load path;
a current sensing component configured to sense the current flow through the load path;
and
an electrostatic discharge "ESD" protection component configured to protect the current-sensing component from an electrostatic discharge, wherein the ESD protection component comprises an ESD transistor, the ESD transistor having a gate which is connected to a discharge path such that the presence of a discharge of a first polarity causes the ESD transistor to switch on to form a further path for dissipation of a discharge.

2. A semiconductor device according to claim 1, wherein an ESD diode is provided in parallel with the ESD transistor, the ESD diode configured to allow current flow from a discharge having a second polarity.

3. A semiconductor device according to any preceding claim, wherein the power switching component comprises a main transistor and the current sensing component comprises a sense transistor.

4. A semiconductor device according to any preceding claim, wherein the main transistor has a first and second terminal and the sense transistor has a first and second terminal, the first terminals being one of a source and drain and the second terminal being the other of a source and drain, the main transistor and sense transistor having their first terminal connected to a common first terminal and the second terminal being connected by a connection path comprising a resistor.

5. A semiconductor device according to claim 4, wherein the gate of the ESD transistor is connected to the connection path comprising the resistor.

6. A semiconductor device according to either of claims 3 or 4, wherein the gate of the ESD transistor is connected to a terminal of the main transistor.

7. A semiconductor device according to any of claims 3 to 7, wherein the sense transistor is configured as a current mirror for the main transistor.

8. A semiconductor device according to any of claims 3 to 7, wherein the main transistor comprises a plurality of component transistors arranged in parallel and the sense transistor comprises at least one of the component transistors, the number of component transistors in the main transistor being larger than the number of component transistor in the sense transistor.

9. A semiconductor device according to claim 8, wherein the ESD transistor comprises a plurality of the component transistors, the number of component transistors in the discharge transistor being larger than the number of component transistors in the sense transistor.

10. A semiconductor device according to either of claims 8 or 9, wherein the component transistors of the ESD transistor are of the same type as the component transistor in the sense transistor.

11. A semiconductor device according to any preceding claim, wherein the ESD protection component comprises a plurality of ESD transistors in parallel with one another.

12. A semiconductor device according to any preceding claim, configured as a monolithic integrated circuit.

13. A semiconductor device comprising:
a power switching component comprising a main transistor configured to control the flow of current through a load path; and
a current sensing component comprising a sense transistor configured to sense the current flow through the load path,
wherein the main transistor has a first and second terminal and the sense transistor has a first and second terminal, the first terminal of the main transistor and sense transistor being one of a source and drain and the second terminal of the main transistor and sense transistor being the other of a source and drain, the main transistor and sense transistor having their first terminal connected to a common first terminal and the second terminal being connected by a connection path comprising a resistor.

14. A semiconductor device according to claim 13, wherein the resistor has a resistance of between 1kΩ - 1MΩ

15. A semiconductor device according to either of claims 13 or 14, further comprising an ESD protection component provided in parallel with the current sensing component, wherein the ESD protection component comprises an ESD transistor, the ESD transistor having a gate which is connected to a discharge path such that the presence of a discharge of a first polarity causes the EST transistor to switch on to form a further path for dissipation of a discharge.
